# EUROPEAN PATENT APPLICATION

(11) **EP 1 871 157 A2**
(43) Date of publication of application: **26.12.2007**
(21) Application number: 07104681.7
(22) Date of filing: 22.03.2007
(51) Int. Cl.: H05K 9/00

(54) **EMI shielding module**

(30) Priority: 21.06.2006 CN 200610086459
(71) Applicant: ASUSTeK Computer Inc., Peitou, Taipei City (TW)
(72) Inventor: Wang, Ching-Jen, Taipei (TW)
(74) Representative: Viering, Jentschura & Partner

(57) **Abstract**

This invention discloses an EMI shielding module installed on the circuit board with at least one connection hole. This EMI shielding module includes a shielding case and at least one protrusion. The shielding case capped on the device is arranged on the circuit board. The protrusion is arranged on the shielding case and inserted in the connection hole. Therefore, the shielding case is grounded by connecting it to the circuit board with the protrusion inserted in the connection hole.

## Description

### BACKGROUND

### Field of Invention

The present invention relates to a shielding module. More particularly, the present invention relates to a shielding module that is grounded by a circuit board.

### Description of Related Art

The high frequency and high speed transmission device are introduced with the improvement of the technology. In the normal operation of electronic devices, there is unintentional generation of electromagnetic energy from the electronic devices. The propagation of the electromagnetic energy saturates the external environment and induces unwanted effects. The electromagnetic energy level relates to the frequency and the return path thereof. Therefore, the electromagnetic energy from the high speed/frequency electronic device (ex. RF IC) induces unwanted effects on other electronic devices. In order to prevent the induced unwanted effects from electromagnetic energy, the EMI (Electro Magnetic Interference) protection is important for high speed/frequency applications.

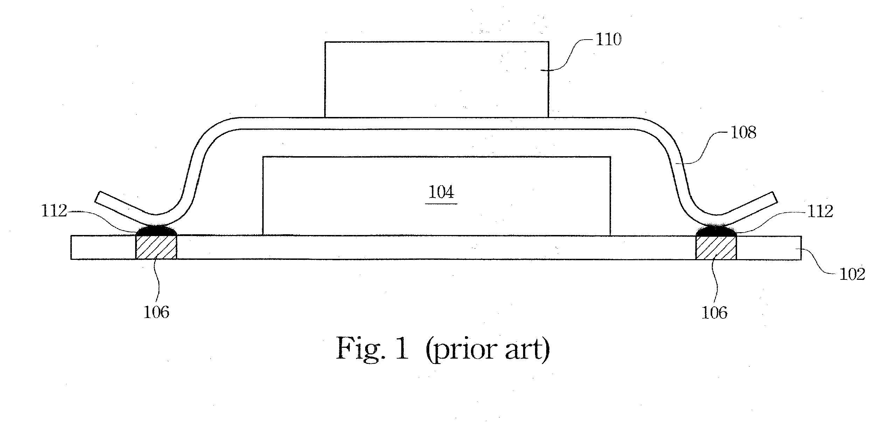

The concept of the EMI protection is to cover a metal member on the electromagnetic source, and ground the metal member. The metal member can discharge the electromagnetic energy to the ground. Refer to Fig. 1. Fig. 1 is a schematic diagram of a cross sectional view of a common electronic device shielding module. The electronic device shielding module includes a circuit board 102, an electronic device 104, ground points 106, and a shielding case 108. The electronic device 104 is configured on the circuit board 102 and capped by a metal member. The metal member can be the shielding case 108. The ground points 106 have solder points 112 on the circuit board 102 surface. The shielding case 108 contacts to the ground point 106 through the solder points 112. Therefore, the shielding case is grounded by the grounding layer of the circuit board 102.

The electric device shielding module further comprises a forcing member 110. The forcing member 110 forces the shielding case 108, so that the shielding case 108 contacts the solder points 112 more tightly. The shape of the forcing member 110 depends on the mechanism design. For example, the forcing member can be a protrusion arranged on one of outside shell. When two outside shell assemble together and cover the circuit board, the protrusion will force the shielding case properly, so that the shielding case could contact with the solder points. Due to the variations of mechanism design, the forcing member can be formed as varied shapes, and a block represents the forcing member 110 in this figure. When the electronic device radiates the electromagnetic energy, the electromagnetic energy will be shielded and absorbed by the shielding case 108. Finally, the electromagnetic energy is discharged to the grounding layer of the circuit board 102.

Unfortunately, if the forcing member 110 cannot provide uniform force for the shielding case 108 or the shielding case 108 has size inaccuracy, the shielding case 108 could not shield the electromagnetic energy completely. Hence the electromagnetic energy induces unwanted effects on other electronic devices.

Therefore, desirable in the art of the shielding module designs are improved structures for better grounding methods in high speed/frequency applications.

### SUMMARY

It is therefore an aspect of the present invention to provide a shielding module grounded by a circuit board for reducing the electromagnetic energy leaking probability, and forming a small return path for the electromagnetic energy.

The EMI shielding module installed on a circuit board with at least one connection hole includes at least one radiation source and a shielding case. The radiation source is arranged on the circuit board. The shielding case covers at least one radiation source. The shielding case further comprisies at least one protrusion corresponding to the connection hole. The protrusion is inserted into the connection hole and soldered on the circuit board. Therefore, the shielding case is grounded directly, and not grounded by contacting other grounding member.

In first embodiment the EMI shielding module for electronic devices is installed on a circuit board with at least one connection hole. The shielding module includes at least one electronic device and a shielding case. The electronic device is configured on the circuit board and capped by the shielding case. The shielding case further comprises at least one protrusion corresponding to at least one connection hole. The protrusion is inserted in the connection hole, and soldered on the circuit board, so that the shielding case is connected to ground.

In the second embodiment, the EMI shielding module for a high-speed electrical connector of a stackable connector assembly is installed on a circuit board with at least one connection hole. The shielding module includes the stackable connector assembly and a shielding case. The stackable connector assembly has a first connector, a second connector, wherein the first connector is a high-speed electrical connector and arranged on the circuit board in this embodiment. The second connector is placed above the first connector. The first connector is capped by the shielding case. The shielding case further comprises at least one protrusion corresponded to the at least one connection hole. The protrusion is inserted in the connection hole, and soldered on the circuit board. Therefore, the shielding case is connected to ground.

In this invention the shielding case is grounded by soldering the protrusion thereof into the connection hole of the circuit board. Due to the connection hole is connected to the ground plane of the circuit, the protrusion is connected to the ground plane of the circuit board tightly. Moreover, the variation number of the protrusion could form small return paths for the electromagnetic energy.

It is to be understood that both the foregoing general description and the following detailed description are examples and are intended to provide further explanation of the invention as claimed.

### BRIEF DESCRIPTION OF THE DRAWINGS

These and other features, aspects, and advantages of the present invention will become better understood with regard to the following description, appended claims, and accompanying drawings where:
Fig. 1 is a schematic diagram of a cross sectional view of a common electronic device shielding module;
Fig. 2 is a schematic diagram of a cross sectional view of a circuit board;
Fig. 3 is a schematic diagram of a top view of first embodiment;
Fig. 4 is a schematic diagram of a cross sectional view of the first embodiment taken along the I-II line from the A direction of Fig. 3;
Fig. 5 is a schematic diagram of a cross sectional view of second embodiment;
Fig. 6 is a schematic diagram of a rear view of the second embodiment taken along III-III' line from the B direction in Fig. 5;
Fig. 7 is a schematic diagram of an EMI testing result of a high-speed electrical connector that without a shielding case;
Fig. 8 is a schematic diagram of an EMI testing result of a high-speed electrical connector with a shielding case grounded using the contact method;
Fig. 9 s a schematic diagram of an EMI testing result of a high-speed electrical connector with a shielding case grounded by a ground plane of a circuit board.

### DESCRIPTION OF THE PREFERRED EMBODIMENTS

Reference is now be made in detail to the present preferred embodiments of the invention, examples of which are illustrated in the accompanying drawings. Wherever possible, the same reference numbers are used in the drawings and the description to refer to the same or like parts.

The shielding case caps on the radiation source. The shielding case includes at least one protrusion soldered in the connection hole of the circuit board. Therefore, the shielding case connects to the ground plane of the circuit board, and the electromagnetic energy radiated from the radiation source is discharged to the ground plane directly. Someone skilled in the art could change the material of the shielding case, the number of the protrusion, and the connection means of the shielding case and the protrusion to satisfy the variation of the application.

The EMI shielding module installed on a circuit board with the connection hole includes at least one radiation source and a shielding case. The radiation source is configured on the circuit board. The shielding case caps on the radiation source. The shielding case has at least one protrusion corresponding to at least one connection hole. The protrusion is inserted in the connection hole, and soldered on the circuit board. Therefore, the shielding case is grounded by soldering it on the circuit board with the at least one protrusion.

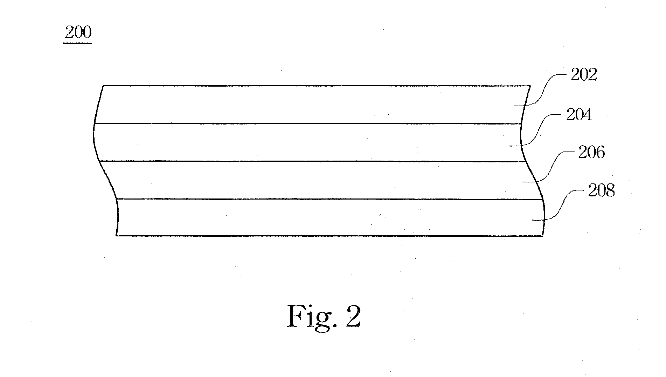

Please refer to Fig. 2. Fig. 2 is a schematic diagram of a cross sectional view of a circuit board 200. The circuit board 200 has at least four variant function layers, a first signal layer 202, a power plane 204, a ground plane 206, and a second signal layer 208. The first signal layer 202 and the second signal layer 208 are used to transmit signals between two electric devices configured on the circuit board. The ground plane 206 is a copper layer that appears to most signals as an infinite ground potential. The power plane 204 is used to provide DC voltage for powering circuits mounted on the circuit board 200.

In all embodiments, the protrusion is soldered on the circuit board. Therefore, the shielding case connecting with the protrusion is grounded by soldering it on the circuit board with the protrusion. The electromagnetic energy then radiates from the radiation source and can be discharged to the ground plane directly.

The shielding case may be a metal case or other EMI shielding compounds. The protrusion is a portion of the shielding case edge, or is at least one metal piece riveted/soldered on the shielding case edge.

Because the shielding case is grounded by soldering it on the circuit board with the at least one protrusion and connected to the ground plane directly. This EMI module prevents the incomplete contact with the solder points due to the size inaccuracy or the nonuniform force, and reduces the probability of electromagnetic energy leakage. Moreover, this invention also provides a small return path for the electromagnetic energy. In order to describe the application of this present invention in detail, the following provides some embodiments for implementing features of this invention. To clearly show at least one connection hole in the figures, there is at least one connection hole that may be slightly exaggerated. Actually, the protrusion corresponds to the connection hole and inserted in the connection hole tightly.

### First Embodiment:

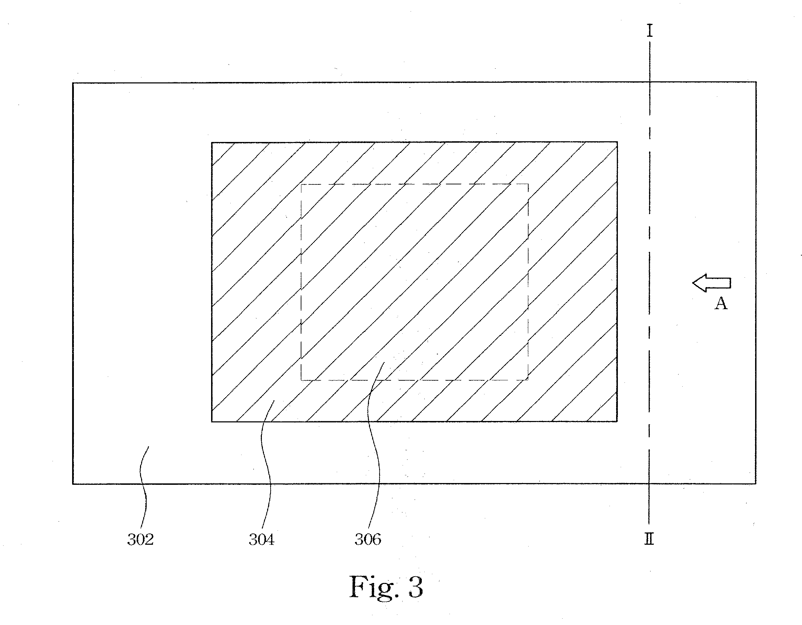

The first embodiment is an application in electronic devices EMI solution. Please refer to Fig. 3. Fig. 3 is a schematic diagram of a top view of an electronic device EMI shielding module. This figure shows a circuit board 302, an electronic device 306, and a shielding case 304. The electronic device 306 is configured on the circuit board 302. The shielding case is capped on the electronic device 306.

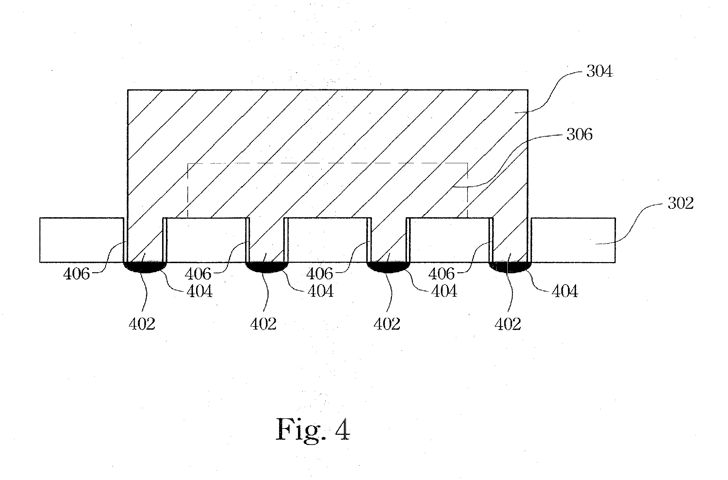

For detail describes the structure of the shielding case 304 arranged on the circuit board 302, please refer to Fig. 4 and Fig 3. Fig. 4 is a schematic diagram of a cross sectional view of the first embodiment taken along the I-II line from the A direction of Fig. 3. The circuit board 302 has predetermined connection holes 406. Protrusions 402 are correspond to connection holes 406 and arranged on the shielding case 304 for insertion into the connection holes 406. Therefore, the protrusions 402 can be soldered on the circuit board 302 with soldering points 404.

In the embodiment, the shielding case 304 is a metal case. The protrusions 402 are a portion of the edges of the shielding case 304 or metal pieces riveted/soldered on the shielding case 304 edges. The protrusion 402 inserted in the connection holes 406 on the circuit board 302 are connected to the shielding case 304, thereby connecting the ground plane of the circuit board 302 to the shielding case 304. Hence the shielding case 304 is typically grounded, the electromagnetic energy from the electronic device 306 can be discharged to the ground plane of the circuit board 302.

There are four protrusions 402 in the one side of the shielding case 304 in this embodiment. To decide the number of protrusions 402, the number of signal wires of the electronic device 306 on the circuit board 302 should be considered. Therefore, the best number of protrusions 402 is corresponded with the variety of situations.

The shielding case is grounded by soldering it to the circuit board with at least one protrusion. Therefore, the shielding case connects to the ground plane of the circuit board, and the leaking probability and the unwanted effects are reduced. Moreover, the protrusion is soldered on the circuit board. Hence, the protrusion is tightly connected to the ground plane of the circuit board. Therefore, the EMI module prevents the incomplete contact with the solder points due to the size inaccuracy or the nonuniform force, and reduces the probability of electromagnetic energy leakage.

### Second embodiment:

Due to the high-speed data transmission interfaces are improved with new technology, the number of the connector arranged on the circuit board is increasing. Stackable connectors provide a convenient way to provide two interface ports to a circuit board without consuming twice the area required on the circuit board for a single connector. To form the small return path for the high-speed data transmission, the high-speed connector is always configured near the circuit board, and the low-speed connector is always placed above the high-speed connector. However, the electromagnetic energy from the high-speed connector in the high-speed data transmission process could induce unwanted effects on the low-speed connector. Moreover, the strength of the electromagnetic energy is increasing with the high frequency. Hence, the stackable connector EMI protection is important. This embodiment applies the EMI shielding module on the stackable connector to reduce the electromagnetic interference.

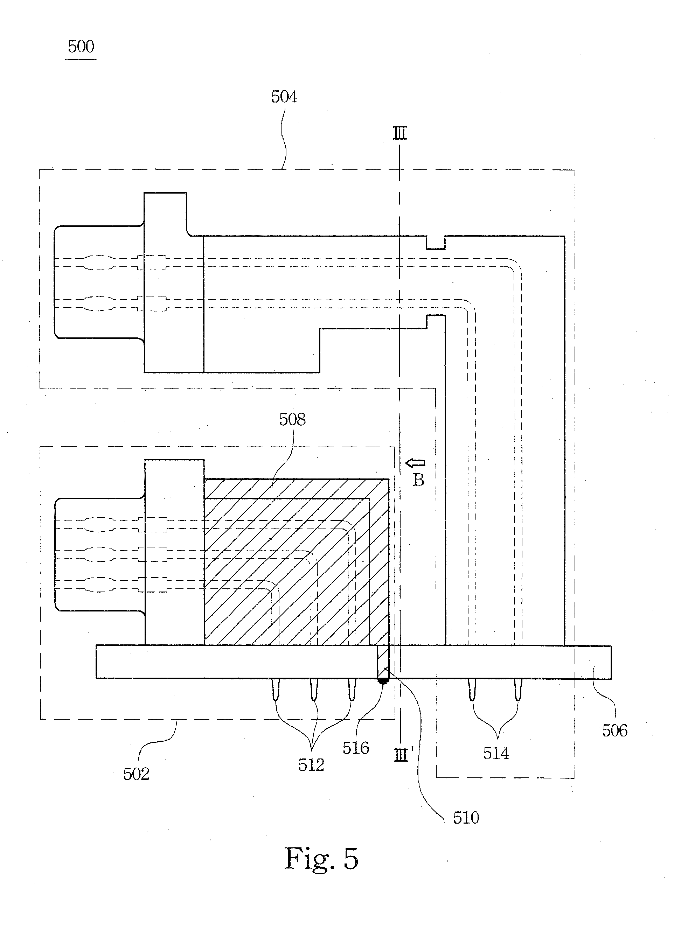

Referring now to Fig. 5, shown therein is a schematic diagram of a cross sectional view of the stackable connector assembly EMI shielding module of this embodiment. The stackable connector assembly 500 includes a first connector 502, a second connector 504, and a shielding case 508. The shielding case 508 is capped on the first connector 502 surface. Moreover, the protrusion 510 is arranged on the shielding case 508.

The first connector 502 is a high-speed electrical connector and the second connector 504 is a low-speed electrical connector. The first connector 502 is soldered on the circuit board 506 with the first connector solder tails 512. The second connector 504 is soldered on the circuit board 506 by the second connector solder tails 514. Therefore, the stackable connector assembly 500 is mounted on the circuit board 506. In this embodiment, the circuit board 506 is a motherboard. In other embodiments, the circuit board could be a printed circuit board.

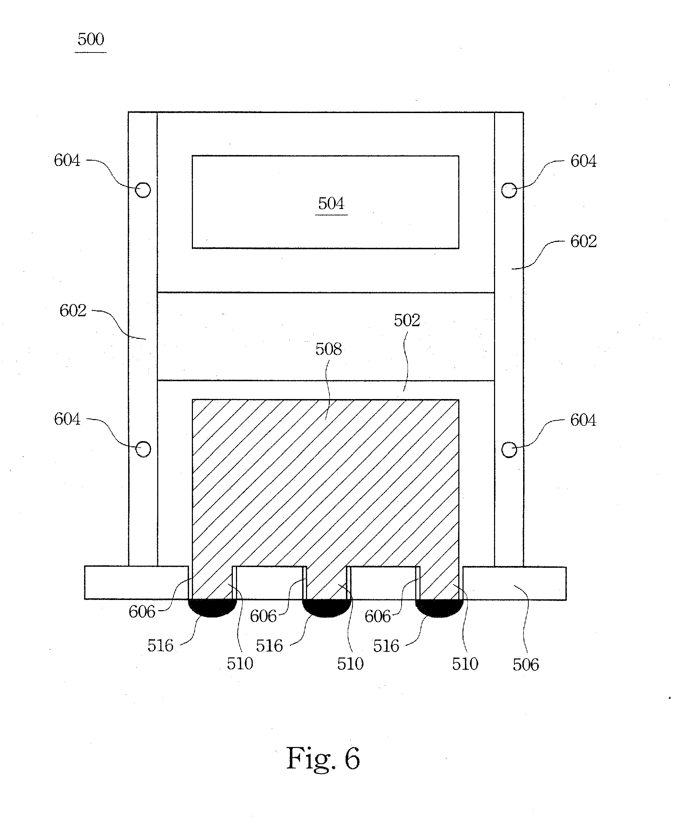

In order to detail describes the structure of the shielding case 508 arranged on the circuit board 506, please refer to Fig. 5 and Fig. 6 together. Fig. 6 is a schematic diagram of a rear view from the B direction of the second embodiment along the III-III' line in Fig. 5. The circuit board 506 has connection holes 606 corresponding to the protrusions 508. The protrusions 508 are inserted in the connection holes 606 and soldered on the circuit board 506 by soldering points 516.

The stackable connector assembly 500 further comprises two metal brackets 602 which include a plurality of mounting apertures 604. The metal brackets 602 are used to mount the first connector 502 and the second connector 504 to form the stackable connector assembly 500. Moreover, the metal brackets 602 are also used to increase the strength of the stackable connector assembly 500 structure.

The first connector 502 and the second connector 504 are installed between the metal brackets 602. These mounting apertures 604 of the metal brackets 602 are correspond to fixing members (not shown) of the first connector 502 and the second connector 504. The first connector 502 and the second connector 504 can be installed between the metal brackets 602 by mounting the fixing members on mounting apertures 604. Moreover, the second connector 504 is placed above the first connector 502. Therefore, the first connector 502 and the second connector 504 are become the stackable connector assembly 500.

In this embodiment, the shielding case 508 is a metal case. The protrusions 510 are a portion of the shielding case 508 edges or metal pieces riveted/soldered on the edges of the shielding case 508. The protrusions 510 are inserted in the connection holes 606 on the circuit board 506 and are connected to the shielding case 508, thereby connecting the ground plane of the circuit board 302 to the shielding case 508. Since the shielding case 508 is typically grounded, the electromagnetic energy from the fist electrical connector 502 can be discharged to the ground plane of the circuit board 302.

There are three protrusions 510 on the shielding case 508 in this embodiment. To decide the number of the protrusions 510, the number of signal wires of the first connector 502 should be considered. If there is only a protrusion arranged on the shielding case, the electromagnetic energy from the signal wire which is far from the protrusion must be discharged through a longer return path. Therefore, the number of protrusions 502 depends on different cases and forms the small return path for the electromagnetic energy from every signal wire.

The shielding case is grounded by soldering it to the circuit board with at least one protrusion. Therefore, the shielding case connects to the ground plane of the circuit board. The shielding case thereby generates the shielding effect on the first connector and reduces the electromagnetic interference of the second connector when the first connector in high-speed data transmission. The protrusions are soldered on the circuit board. Hence, the protrusion is connected the ground plane of the circuit board tightly. The EMI module prevents the incomplete contact with the solder points due to the size inaccuracy or the nonuniform force, and reduces the probability of electromagnetic energy leaking. Moreover, the number of protrusions could depend on the number of signal wires of the first connector to let all electromagnetic energy from the signal wire can be discharged to the ground plane by the small return path.

To know the impact of the embodiments of this invention, there is an EMC testing result for three samples. These three samples are (a) a high-speed electrical connector without a shielding case, (b) a high-speed electrical connector with a shielding case that is grounded by contacting to an external element, and (c) a high-speed electrical connector with a shielding case that is grounded by a ground plane of a circuit board directly. The sample (c) corresponds to the second embodiment of the present invention.

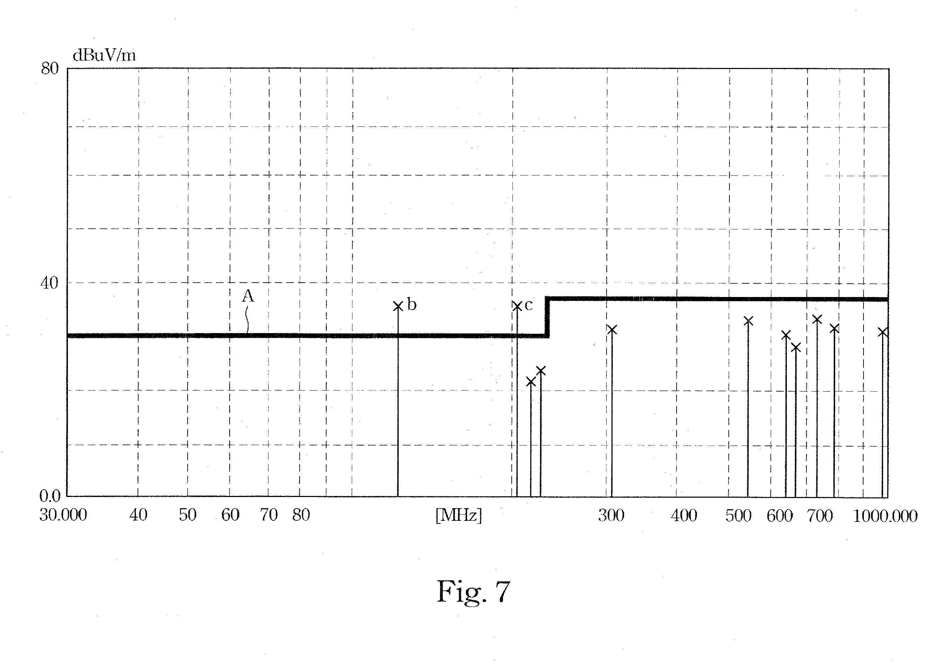

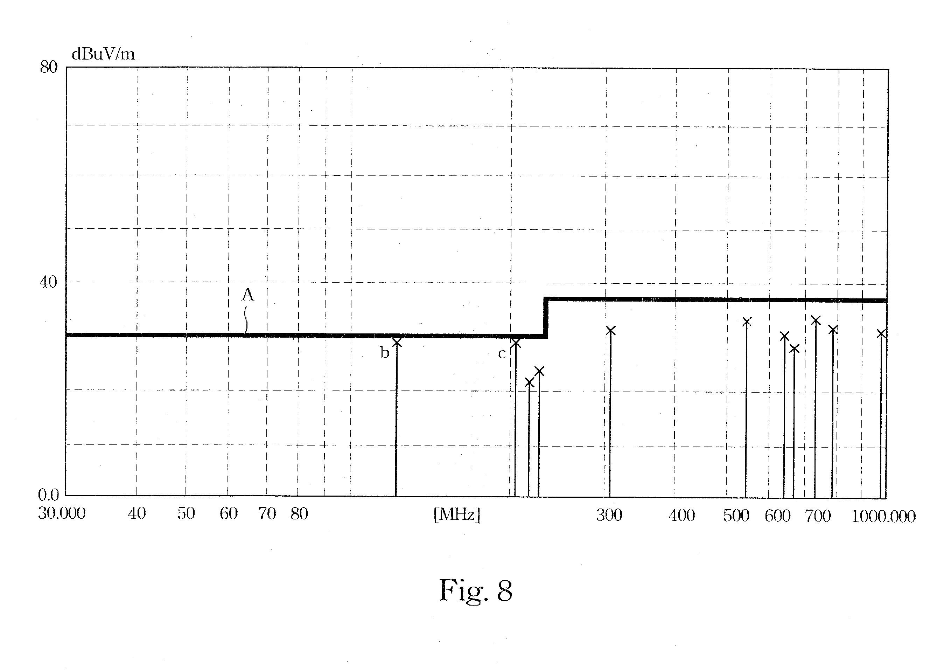

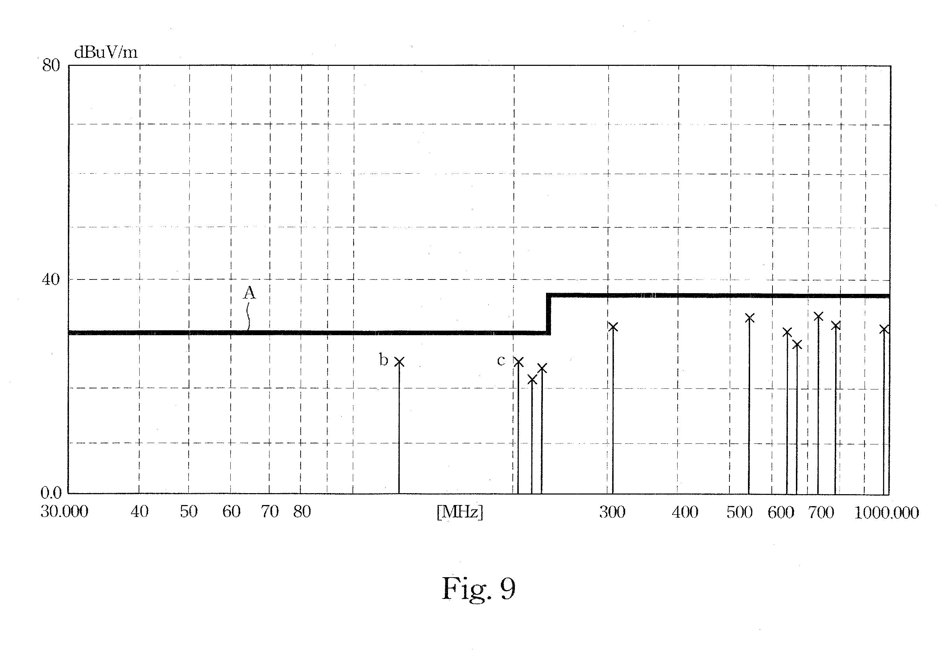

Please refer to Fig. 7, Fig. 8, and Fig. 9. These three figured are the intensity of the electromagnetic energy when the stackable connector assembly in the data transmission. Fig. 7 is a schematic diagram of an EMI testing result for a high-speed electrical connector without a shielding case. Fig. 8 is a schematic diagram of an EMI testing result for a high-speed electrical connector with a shielding case that is grounded by the contact method. Fig. 9 is a schematic diagram of an EMI testing result for a high-speed electrical connector with a shielding case that is grounded with a circuit board ground plane directly. In these three figures, the longitudinal axis is the radiated emission level, the horizontal axis is the frequency value and line A is the standard and regulation value. The intensity of the electromagnetic radiation cannot be above A.

In these three figures, the intensity of the frequency b and c are radiated from the first connector. Compare and contrast the intensity of b and c frequencies of these three figures. The intensity of b and c frequencies in Fig. 7 are all above A. In Fig. 8, the intensity of b and c frequencies are all below A. Focusing on Fig. 9, the intensity of b and c frequency are not only below A, they are still much lower than A. It is known the EMI module of the embodiment prevents better shielding effect on the first connector.

For these testing results, it is understood that the shielding case caps on the high-speed connector and the shielding case grounded by connecting it to the ground plane of the circuit board with the protrusions can reduce the electromagnetic interference efficiently through the small return path. Moreover, the shielding case is grounded by soldering it to the circuit board with at least one protrusion. Therefore, the EMI module prevents the shielding case has incomplete contact with the solder points and provides a better shielding design for the radiation source and provides a complete EMI protection for other electronic devices..

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims and their equivalents.

## Claims

1. An electronic device EMI shielding module installed on a circuit board with at least one connection hole, the electronic device EMI shielding module comprising:
at least one electronic device configured on the circuit board; and
a shielding case capped on at least one electronic device, the shielding case having at least one protrusion corresponding to at least one connection hole and capable of inserting into at least one connection hole for grounding the shielding case.

2. The electronic device EMI shielding module of claim 1, wherein the circuit board further comprises:
a first signal layer;
a voltage plane;
a ground plane; and
a second signal layer.

3. The electronic device EMI shielding module of claim 1, wherein the shielding case is a metal case.

4. The electronic device EMI shielding module of claim 1, wherein the at least one protrusion is a portion of the shielding case edge, or a metal piece riveted on the shielding case edge.

5. The electronic device EMI shielding module of claim 1, wherein the at least one protrusion is a metal piece soldered on the shielding case edge.

6. A stackable connector assembly EMI shielding module installed on a circuit board with at least one connection hole, the stackable connector assembly EMI shielding module comprising:
a first connector configured on the circuit board;
a second connector placed above the first connector;
a shielding case capped on the first connector surface, the shielding case having at least one protrusion correspond to at least one connection hole and capable of inserting into at least one connection hole.

7. The stackable connector assembly EMI shielding module of claim 6, wherein the circuit board further comprises:
a first signal layer;
a voltage plane;
a ground plane; and
a second signal layer.

8. The stackable connector assembly EMI shielding module of claim 6, wherein the circuit board is a motherboard or a printed circuit board.

9. The stackable connector assembly EMI shielding module of claim 6, wherein the shielding case is a metal case.

10. The stackable connector assembly EMI shielding module of claim 6, wherein the at least one protrusion is a portion of the shielding case edge, or a metal piece riveted on the shielding case edge.
